# EUROPÄISCHE PATENTSCHRIFT

(11) **EP 1 640 159 B1**
(45) Veröffentlichungstag und Bekanntmachung des Hinweises auf die Patenterteilung: **18.06.2008**
(21) Anmeldenummer: 05020643.2
(22) Anmeldetag: 22.09.2005
(51) Int. Cl.: B41C 1/10, F27B 9/10, F27B 9/24

(54) **Vorrichtung zum Wärmebehandeln einer Beschichtung von Flachoffset-Druckplatten**
Device for heat treating the coating of flat offset printing plates
Dispositif pour le traitement thermique du revêtement de plaques d'impression offset

(30) Priorität: 25.09.2004 DE 202004014949 U
(43) Veröffentlichungstag der Anmeldung: 29.03.2006
(73) Patentinhaber: Techno-Grafica GmbH, 75236 Kämpfelbach (DE)
(72) Erfinder: Hanosek, Peter, 75236 Kämpfelbach (DE)
(74) Vertreter: Twelmeier Mommer & Partner

(56) Entgegenhaltungen:
- EP-A1- 0 461 961
- EP-A1- 1 024 403
- WO-A-94/06593

## Beschreibung

Die Erfindung befasst sich mit einer Vorrichtung zum Wärmebehandeln der belichteten oder unbelichteten Beschichtung von Flachoffset-Druckplatten im Durchlauf. Flachoffset-Druckplatten haben eine lichtempfindliche Beschichtung, zum Beispiel auf der Grundlage einer Diazo-Schicht, welche durch einen Belichtungsvorgang entsprechend dem zu erzeugenden Druckbild strukturiert wird. Träger der Beschichtung ist eine Platte aus Metall, welche typisch 0,15 mm bis 0,5 mm dick ist und in den meisten Fällen aus Aluminium besteht, in selteneren Fällen auch aus einem anderen Metall oder einer Metallegierung, zum Beispiel aus einer harten Kupfer-Chrom-Legierung. Nach dem Belichten wird die Flachoffset-Druckplatte nasschemisch entwickelt, gewaschen, getrocknet und wärmebehandelt, um die Härte der entwickelten Beschichtung zu steigern. Die Wärmebehandlung wird auch als Einbrennen bezeichnet und kann auch vor dem Belichten erfolgen.

Die Lebensdauer einer Flachoffset-Druckplatte, d. h. die Anzahl der Drucke, die mit ihr hergestellt werden können, hängt von der Härte der Beschichtung ab. Um die Beschichtung zu härten, ist es bekannt zum Beispiel aus EP 1 024 403, von oben her mit Heizstrahlern oder mit Heißluft auf die Flachoffset-Druckplatten einzuwirken, wobei je nach Art der Beschichtung Temperaturen bis zu 300 °C auf der Flachoffset-Druckplatte erreicht werden können.

Bei der Wärmebehandlung von belichteten oder nicht belichteten Flachoffset-Druckplatten gibt es zwei große Probleme:

Zum einen erfolgt die Härtung der Beschichtung nicht gleichmäßig. Nach der Wärmebehandlung hat die Beschichtung nicht überall auf der Flachoffset-Druckplatte dieselbe Härte. Die Lebensdauer der Flachoffset-Druckplatte wird aber durch die Stelle durch die geringsten Härte bestimmt. Um eine möglichst hohe Lebensdauer zu erhalten, ist es deshalb wünschenswert, wenn die Härte der Beschichtung auf der Flachoffset-Druckplatte möglichst überall die gleiche ist.

Zum anderen zeigt sich, dass Flachoffset-Druckplatten infolge der Wärmebehandlung dazu neigen, wellig zu werden, wobei diese Neigung um so ausgeprägter ist, je größer und je dünner die Flachoffset-Druckplatten sind. Es wurde beobachtet, dass die Welligkeit bis zu 4 cm betragen kann. Die Welligkeit ist hinderlich beim Aufspannen der Druckplatte auf den Druckzylinder. Zwar kann die Flachoffset-Druckplatte durch das Aufspannen auf einen Druckzylinder gerichtet und ihre Welligkeit weitgehend beseitigt werden, doch ist das mühsam. Besonders nachteilig wirkt sich die Welligkeit auf modernen Rollenoffset-Druckmaschinen aus, welche mit einer Einrichtung zum automatischen Einziehen für die Flachoffset-Druckplatten ausgestattet sind. Zu diesem Zweck werden die Flachoffset-Druckplatten in ein Magazin gestellt, aus welchen sich die Rollenoffset-Druckmaschine die jeweils benötigte Druckplatte selbsttätig holt und sie auf die Druckwalze spannt. Dafür sind an der Druckwalze schmale, an die Dicke der Flachoffset-Druckplatte angepasste Einführungs- und Halteschlitze vorgesehen, in welche die Flachoffset-Druckplatte einzuführen ist. Eine wellige Flachoffset-Druckplatte läßt sich jedoch nur schwer oder gar nicht automatisch einziehen. In Störungsfällen von Hand nachzuhelfen ist bei einer Rollenoffset-Druckmaschine mit automatischer Einzugseinrichtung praktisch nicht möglich. Bleibt die Flachoffset-Druckplatte beim Einzugsvorgang stecken, bevor sie korrekt eingespannt ist, kann es zur Zerstörung der Druckplatte oder - noch schlimmer - zur Beschädigung der Druckwalze kommen.

Moderne Rollenoffset-Druckmaschinen sind so teuer, dass man alles daran setzt, um Stillstandszeiten so kurz wie möglich zu halten. Nach Möglichkeit sollen die Maschinen pausenlos im Dreischichtbetrieb laufen. Es besteht deshalb ein starkes Interesse daran, wellige Flachoffset-Druckplatten möglichst zu vermeiden.

Der vorliegenden Erfindung liegt deshalb die Aufgabe zugrunde, einen Weg aufzuzeigen, wie man zu gleichmäßiger gehärteten Beschichtungen und weniger welligen Flachoffset-Druckplatten gelangen kann.

Diese Aufgabe wird gelöst, durch eine Vorrichtung, mit den im Anspruch 1 angegebenen Merkmalen. Vorteilhafte Weiterbildungen der Erfindung sind Gegenstand der Unteransprüche.

Die erfindungsgemäße Vorrichtung hat eine obere Heißluftkammer und eine untere Heißluftkammer, welche mit Abstand unter der oberen Heißluftkammer angeordnet ist. Im Zwischenraum zwischen den beiden Heißluftkammern ist das Obertrum eines luftdurchlässigen endlosen Förderbandes angeordnet, welches zwischen den beiden Heißluftkammern verläuft und dazu dient, die Flachoffset-Druckplatten durch den Zwischenraum zwischen den beiden Heißluftkammern hindurch zu fördern. Mit Ausnahme einer Eintrittsöffnung und einer Austrittsöffnung für das Obertrum des Förderbandes ist der Zwischenraum zwischen den beiden Heißluftkammern nach außen hin abgeschlossen. An der Unterseite der oberen Heißluftkammer ist ein erster Luftverteiler vorgesehen. An der Oberseite der unteren Heißluftkammer ist ein zweiter Luftverteiler vorgesehen. Die beiden Luftverteiler haben mehrere dem Förderband zugewandte Luftaustrittsöffnungen und wenigstens eine Lufteintrittsöffnung, welche mit der der Saugseite eines oder mehrerer Gebläse in Verbindung steht. Die Erfindung hat wesentliche Vorteile:
◆ Durch die beidseitige Beaufschlagung mit Heißluft erwärmt sich die Druckplatte schneller und gleichmäßiger.
◆ Die Luftverteiler, welche der oberen Heißluftkammer und der unteren Heißluftkammer zugeordnet sind, können durch ihre Luftaustrittsöffnungen die Luft so verteilen, dass sich eine gleichmäßige Erwärmung der Druckplatte ergibt.
◆ Strukturelle Unterschiede in der Wärmeleitfähigkeit der Flachoffset-Druckplatte beeinträchtigen die Gleichmäßigkeit der Erwärmung weniger als bisher.
◆ Die gleichmäßigere Erwärmung der Flachoffset-Druckplatte verringert deren Neigung, sich zu verziehen.
◆ Die schnellere Erwärmung der Flachoffset-Druckplatte verringert ebenfalls deren Neigung, sich zu verziehen.
◆ Es hat sich gezeigt, dass die Temperatur ohne Einbuße an Härte 20°C bis 30°C niedriger gewählt werden kann als im Stand der Technik. Das verringert nicht nur die Neigung der Flachoffset-Druckplatten, wellig zu werden, sondern verringert auch potentielle Temperaturgradienten und führt somit zu einer gleichmäßigeren Härtung der belichteten Beschichtung.
◆ Die Erwärmung und Härtung der Druckplatten und ihrer Beschichtung erfolgt schneller, aber ohne die Gefahr von lokalen Überhitzungen.
◆ Durch die schnellere Erwärmung und Härtung kann der Durchsatz durch die Vorrichtung gesteigert werden. In einer praktisch ausgeführten Maschine konnte die Durchlaufgeschwindigkeit des Förderbandes von 60 cm pro Minute auf 110 cm pro Minute gesteigert werden. Das ist von besonderem Vorteil, weil sich die Vorrichtung zum Einbrennen damit auch problemlos an eine moderne, schnell laufende Belichtungsmaschine anschließen läßt.

Das Förderband kann in an sich bekannter Weise auf der Außenseite der Vorrichtung umgelenkt und von seiner Austrittsöffnung zu seiner Eintrittsöffnung zurückgeführt werden. Die Rückführung könnte durch einen warmen Abschnitt der Vorrichtung hindurch erfolgen. Einfacher und für die Gleichmäßigkeit der Erwärmung der Flachoffset-Druckplatten ist es jedoch, wenn das Förderband unterhalb der unteren Heißluftkammer frei durch die umgebende Luft zurückgeführt wird, so dass es auf dem Weg zur Eintrittsöffnung abkühlen kann.

Das Material für das Förderband wird selbstverständlich so gewählt, dass es den auftretenden Temperaturen und den Zugkräften Stand hält. Wichtig ist, dass das Förderband den Durchtritt der umgewälzten Heißluft ermöglicht und so wenig wie möglich behindert. Vorzugsweise besteht das Förderband aus einem grobmaschigen Drahtgeflecht oder aus einem Metallringgeflecht aus einem Metall oder einer Metallegierung mit einer möglichst geringen Wärmeleitfähigkeit, wesentlich geringer als die von Kupfer oder Aluminium. Dadurch sollen an den Berührungspunkten zwischen der Flachoffset-Druckplatte und dem Förderband Temperaturspitzen soweit wie möglich vermieden werden. Dazu trägt die grobmaschige Struktur des Förderbandes bei, welche es leicht macht, dass die Heißluft das Förderband in allen Richtungen durchströmt.

Die Luftverteiler, welche die obere Heißluftkammer nach unten und die untere Heißluftkammer nach oben begrenzen sollen, soll dafür sorgen, dass die Heißluft gleichmäßig auf die Flachoffset-Druckplatten verteilt wird, während diese durch die Vorrichtung hindurch bewegt werden. Zu diesem Zweck erstrecken sich die Luftaustrittsöffnungen der Luftverteiler vorzugsweise über die gesamte Breite des Förderbandes. Das bedeutet nicht, dass sich die Luftaustrittsöffnungen in Form von Schlitzen ohne Unterbrechung über die gesamte Breite des Förderbandes erstrecken müssen, Vielmehr kann es sich um einzelne Schlitze oder um runde oder längliche Löcher handeln, welche aufgereiht so angeordnet sind, dass sie sich im wesentlichen über die gesamte Breite des Durchgangs erstrecken, in welchem die Druckplatten die Vorrichtung durchqueren. "Im wesentlichen" ist in diesem Zusammenhang so zu verstehen, dass die Breite, über welche sich die Luftaustrittsöffnungen erstrecken, hinreichend groß ist, um die gewünschte Gleichmäßigkeit der Erwärmung und Härtung der belichteten Beschichtung zu erreichen. Vorzugsweise werden mehrere solche Reihen von Luftaustrittsöffnungen in Förderrichtung hintereinander angeordnet, wobei als Luftaustrittsöffnungen Schlitze bevorzugt sind, die quer, insbesondere rechtwinklig zur Förderrichtung des Förderbandes verlaufen.

Es wird angestrebt, dass bereits durch die Wahl der Anordnung der Luftaustrittsöffnungen im Luftverteiler die erwünschte gleichmäßige Erwärmung der Druckplatten erzielt wird. Um bei auftretenden Ungleichmäßigkeiten die Wärmeübertragung und Härtung der belichteten Beschichtung die räumliche Verteilung der Heißluftströmungen in der Vorrichtung nachjustieren zu können, ist wenigstens bei einem Teil der Luftaustrittsöffnungen deren Weite verstellbar. Die Verstellung kann von Hand vorgenommen werden. Sie kann allerdings auch motorisch bewirkt werden. Eine motorische Verstellung hat den Vorteil, dass sie es erlaubt, den Austritt der Heißluft nach technischen Vorgaben zu steuern und zum Beispiel über die Länge des Durchgangs durch die Einbrennvorrichtung wählbare Temperaturprofile einzustellen.

Um die Weite der Luftaustrittsöffnungen zu verstellen, sind vorzugsweise Blenden vorgesehen. Im Falle von schlitzförmigen Öffnungen kann es sich dabei um Schieber handeln, welche quer zu den Schlitzen verschiebbar sind und auf diese Weise die effektive Schlitzbreite zu verändern erlauben.

Vorzugsweise erstrecken sich die einzelnen Blenden wie die Schlitze auch nicht über die gesamte Breite des Förderbandes, sondern nur über einen Teil des Förderbandes, um etwaige, über die Breite des Förderbandes auftretende Ungleichmäßigkeiten in der Temperaturverteilung verringern zu können.

Die Heißluft, welche aus den Luftaustrittsöffnungen der Heißluftkammern austritt und auf die Druckplatten trifft, ist zurückzuführen. Dafür hat jede Heißluftkammer wenigstens eine Lufteintrittsöffnung. Diese kann sich als Schlitz über die gesamte Breite des Förderbandes erstrecken und sollte eine unmittelbare Verbindung zur Saugseite von einem oder mehreren Gebläsen haben, welche für die Umwälzung von Heißluft in der Einbrennvorrichtung sorgen. Eine Blende zur Verstellung der Lufteintrittsöffnungen ist vorzugsweise nicht vorgesehen.

Damit es zu einer Luftumwälzung kommt, benötigt man zu beiden Seiten des Förderbandes wenigstens ein Gebläse, welches sich zweckmäßigerweise hinter dem Luftverteiler in der jeweiligen Heißluftkammer befindet, wobei die jeweilige Lufteintrittsöffnung dicht vor der Saugseite des betreffenden Gebläses liegen sollte. Die in die Heißluftkammer gesaugte Luft wird von den Gebläsen zweckmäßigerweise an elektrischen Heizeinrichtungen vorbei geleitet, insbesondere an Rohrheizkörpern, wird dabei erwärmt und tritt aus den Luftaustrittsöffnungen wieder aus. Um definierte Strömungsverhältnisse zu erhalten, ist die Leistung der Gebläse auf die lichten Querschnitte der Luftaustrittsöffnungen vorzugsweise in der Weise abgestimmt, dass man in den Heißluftkammern auf der Druckseite der Gebläse einen deutlichen Staudruck erzielt, der vor allen Luftaustrittsöffnungen gleich groß ist.

Als Luftverteiler dient vorzugsweise eine Platte, in welcher die Lufteintrittsöffnungen und die Luftaustrittsöffnungen ausgebildet sind. Die Lufteintrittsöffnungen liegen vorzugsweise in der Mitte zwischen der Eintrittsöffnung und der Austrittsöffnung der Vorrichtung für das Förderband, wohingegen die Luftaustrittsöffnungen zu beiden Seiten der Lufteintrittsöffnungen angeordnet sind. Das hat zur Folge, dass die Heißluft die Druckplatten auf der ersten Hälfte ihres Weges durch die Vorrichtung im Gleichstrom und auf der zweiten Hälfte ihres Weges im Gegenstrom beaufschlagt, was ich als günstig für das Erzielen einer gleichmäßigen Erwärmung der Druckplatten und Härtung ihrer Beschichtung erwiesen hat.

Ein Ausführungsbeispiel der Erfindung ist schematisch in den beigefügten Zeichnungen dargestellt.
- Figur 1: zeigt eine Einbrennvorrichtung in einer Seitenansicht,
- Figur 2: zeigt die Einbrennvorrichtung in einer Schrägansicht,
- Figur 3: zeigt die Einbrenneinrichtung in der Rückansicht,
- Figur 4: zeigt die Einbrenneinrichtung in einem vertikalen Längsschnitt, und

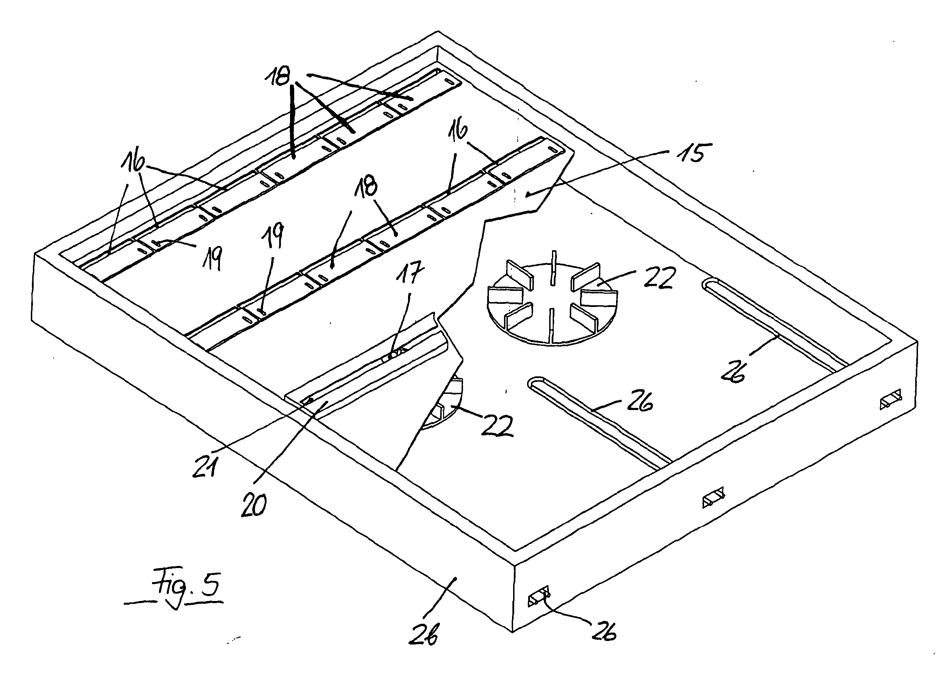

- Figur 5: zeigt als Detail die untere Heißluftkammer mit teilweise weggebrochenem Luftverteiler.

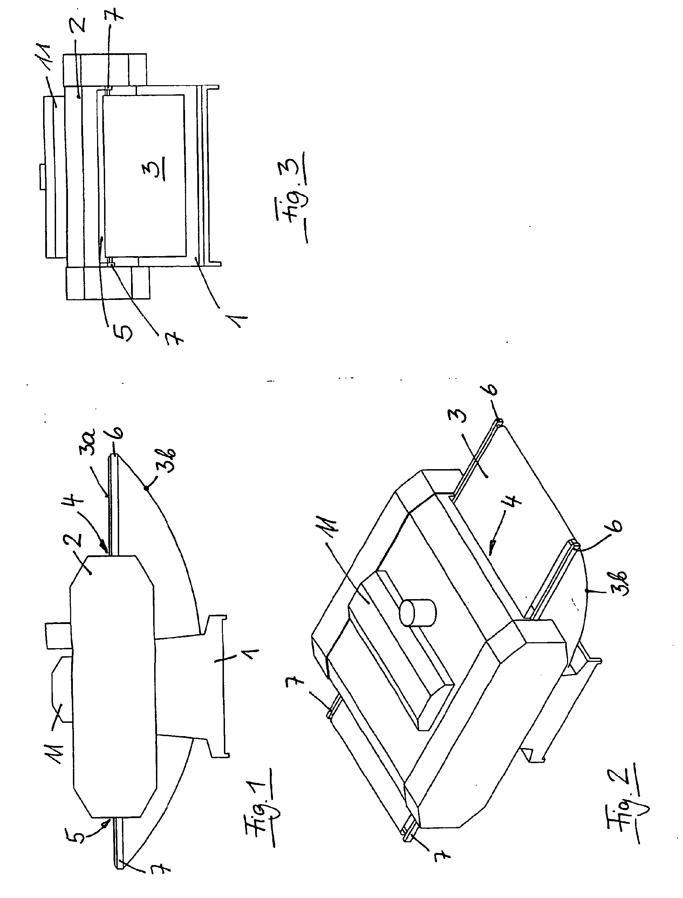

Die in den Figuren 1 bis 3 von außen dargestellte Vorrichtung hat auf einem Gestell 1 ein Gehäuse 2, durch welches ein endloses Förderband 3 hindurch läuft. Das Gehäuse hat eine waagerechte schlitzförmige Eintrittsöffnung 4, durch welche das Förderband 3 eintritt, und eine waagerechte, schlitzförmige Austrittsöffnung 5, durch welche das Förderband 3 austritt. Vor der Eintrittsöffnung 4 sind zwei Ausleger 6 angebaut, welche eine freilaufende Umlenkwalze 8 tragen. Vor der Austrittsöffnung 5 sind zwei Ausleger 7 angebaut, welche eine angetriebene Umlenkwalze 9 tragen, welche das Obertrum 3a des Förderbandes 3 straff durch das Gehäuse 2 hindurch zieht, wohingegen das Untertrum 3b frei durchhängend zur Umlenkwalze 8 zurückgeführt wird.

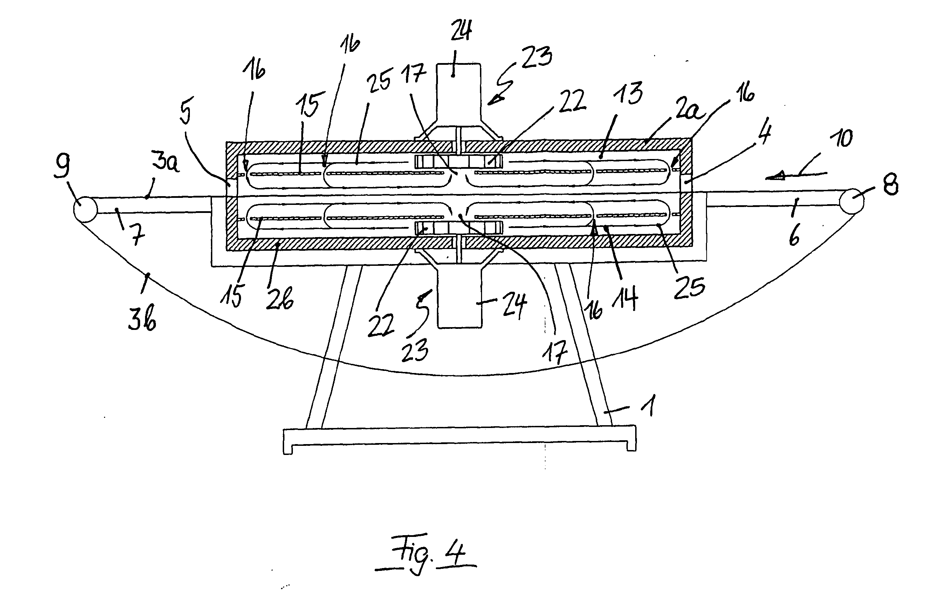

Unter einer Haube 11 auf dem Gehäuse 2 befinden sich die Antriebsmotoren 24 von zwei Gebläsen 12, siehe Figur 4. Die Antriebsmotoren von zwei weiteren Gebläsen befinden sich, in den Figuren 1 bis 3 nicht zu sehen, an der Unterseite des Gehäuses 2.

In dem Gehäuse 2 sind eine obere Heißluftkammer 13 und eine untere Heißluftkammer 14 ausgebildet. Zu diesem Zweck besteht das Gehäuse 2 aus einer oberen Halbschale 2a und aus einer unteren Halbschale 2b mit rechteckigem Grundriss. Die beiden Halbschalen 2a und 2b sind an den einander zugewandten Seiten offen und zusammengefügt. In jeder der beiden Halbschalen 2a, 2b befindet sich etwa in halber Höhe ein Luftverteiler 15, bei welchem es sich um eine waagerechte Platte aus Blech handelt, welche sich über die gesamte Länge und Breite der betreffenden Halbschalen 2a und 2b erstreckt. Beide Luftverteiler 15 haben mehrere zueinander parallele Reihen von Luftaustrittsöffnungen 16 und zwei Lufteintrittsöffnungen 17, welche sich in der Mitte zwischen der Eintrittsöffnung 4 und der Austrittsöffnung 5 des Gehäuses 2 befinden. Die Luftaustrittsöffnungen 16 sind zu beiden Seiten der Lufteintrittsöffnungen 17 angeordnet. Bei den Luftaustrittsöffnungen 16 handelt es im vorliegenden Fall um vier Reihen von Schlitzen, welche sich im wesentlichen über die gesamte Breite der Halbschalen 2a und 2b erstrecken und deren Weite einzeln durch Blenden 18 verstellt werden kann. Bei den Blenden 18 handelt es sich um Bleche, welche Langlöcher 19 aufweisen, mit deren Hilfe sie auf den Luftverteilern 15 verschraubt sind. Nach Lösen der Schrauben können die Blenden 18 in der Förderrichtung 10 oder entgegen der Förderrichtung 10 verschoben und in geänderter Lage wieder fixiert werden. Die Lufteintrittsöffnungen 17 sind beispielsweise kreisrunde Bohrungen, welche auf der dem Förderband 3 zugewandten Seite des Luftverteilers 15 in einen Kanal 20 münden, welcher sich über die gesamte Breite der Halbschalen 2a, 2b erstreckt und einen sich fast über die gesamte Breite der Halbschalen 2a, 2b erstreckenden Schlitz 21 hat, welcher dem Förderband 3 zugekehrt ist. Die Lufteintrittsöffnungen 17 befinden sich in der Flucht der Drehachsen von Rotoren 22 von zwei Radialgebläsen 12, deren Antriebsmotoren 24 auf der Außenseite der Halbschalen 2a bzw. 2b angebracht sind. Die Radialgebläse 12 saugen die Luft aus dem Zwischenraum zwischen dem Luftverteiler 15 und dem Förderband 3 durch die Lufteintrittsöffnungen 17 an und führen die Luft nach Erwärmung über die Schlitze 16 in eben diesen Zwischenraum zurück, wie es durch die Pfeile 25 in Figur 4 dargestellt ist. Auf diese Weise findet über die gesamte Länge und Breite des Raumes zwischen den beiden Luftverteilern 15 ein ständiger Luftaustausch statt, der durch Verstellen der Blenden 19 nach Bedarf noch fein justiert werden kann.

Zu beiden Seiten der Radialgebläse 12 befinden sich in den beiden Heißluftkammern 13 und 14 elektrische Rohrheizkörper 26, an denen die gleichmäßig umgewälzte Luft erhitzt werden kann. Im Bereich zwischen den beiden Luftverteilern 15 können die Temperatur und die Temperaturverteilung durch elektrische Temperaturmessfühler, zum Beispiel durch Thermoelemente, überwacht, die Heizleistung der Rohrheizkörper 26 entsprechende gesteuert und die Gleichmäßigkeit der Temperaturverteilung mit Hilfe der Blenden 18 nach Bedarf justiert werden.

Die beiden Halbschalen 2a, 2b und ebenso die Luftverteiler 15 bestehen vorzugsweise aus einem blanken Edelstahl, welcher sich für Zwecke der Erfindung besonders bewährt hat, weil er nur geringfügig zum Verziehen neigt.

Die Flachoffset-Druckplatten, deren Schichten eingebrannt werden sollen, werden auf den vor der Eintrittsöffnung 4 liegenden Abschnitt 27 des Obertrums 3a des Förderbandes 3 aufgegeben, durchwandern den beheizten Innenraum der Vorrichtung, werden darin von beiden Seiten her gleichmäßig erwärmt und verlassen das Gehäuse 2 wieder durch die Austrittsöffnung 5.

### Bezugszeichenliste:

- 1.: Gestell
- 2.: Gehäuse
- 2a.: Halbschale
- 2b.: Halbschale
- 3.: Förderband
- 3a.: Obertrum
- 3b.: Untertrum
- 4.: Eintrittsöffnung
- 5.: Austrittsöffnung
- 6.: Ausleger
- 7.: Ausleger
- 8.: Walze
- 9.: Walze
- 10.: Förderrichtung
- 11.: Haube
- 12.: Gebläse
- 13.: obere Heißluftkammer
- 14.: untere Heißluftkammer
- 15.: Luftverteiler
- 16.: Luftaustrittsöffnungen
- 17.: Lufteintrittsöffnungen
- 18.: Blenden
- 19.: Langlöcher
- 20.: Kanal
- 21.: Schlitz
- 22.: Rotor
- 23:
- 24.: Antriebsmotor
- 25.: Pfeile
- 26.: Rohrheizkörper
- 27.: Abschnitt des Förderbandes 3

## Patentansprüche

1. Vorrichtung zum Wärmebehandeln einer Beschichtung von Flachoffset-Druckplatten durch Beaufschlagen der Flachoffset-Druckplatten mit Heißluft, **dadurch gekennzeichnet, dass**
- eine obere Heißluftkammer (13)
- eine untere Heißluftkammer (14), welche mit Abstand von der oberen Heißluftkammer (13) unter dieser angeordnet ist,
- ein luftdurchlässiges endloses Förderband (3) mit einem Obertrum (3a), welches zwischen der oberen und der unteren Heißluftkammer (13, 14) verläuft,
- mit einem ersten Luftverteiler (15) an der Unterseite der oberen Heißluftkammer (13),
- mit einem zweiten Luftverteiler (15) an der Oberseite der unteren Heißluftkammer (14),
wobei die beiden Luftverteiler (15) dem Förderband (3) zugewandte Luftaustrittsöffnungen (16) und wenigstens ein Lufteintrittsöffnung (17) haben, welche mit der Saugseite eines oder mehrerer Gebläse (12) in Verbindung steht,
und der Raum zwischen den beiden Heißluftkammern (13, 14) bis auf eine Eintrittsöffnung (4) für das Obertrum (3a) und bis auf eine Austrittsöffnung (5) für das Obertrum (3a) des Förderbandes (3) abgeschlossen ist.

2. Vorrichtung nach Anspruch 1, **dadurch gekennzeichnet, dass** die Eintrittsöffnung (4) und die Austrittsöffnung (5) schlitzförmig sind.

3. Vorrichtung nach Anspruch 1 oder 2, **dadurch gekennzeichnet, dass** das Untertrum (3b) des Förderbandes (3) unterhalb der unteren Heißluftkammer (14) zurückgeführt wird.

4. Vorrichtung nach Anspruch 3, **dadurch gekennzeichnet, dass** das Untertrum (3b) des Förderbandes (3) frei durch die umgebende Luft zurückgeführt wird.

5. Vorrichtung nach einem der vorstehenden Ansprüche, **dadurch gekennzeichnet, dass** das Förderband (3) aus einem Drahtgeflecht oder aus einem Metallringgeflecht besteht.

6. Vorrichtung nach einem der vorstehenden Ansprüche, **dadurch gekennzeichnet, dass** sich die Luftaustrittsöffnungen (16) über die gesamte Breite des Förderbandes (3) erstrecken.

7. Vorrichtung nach einem der vorstehenden Ansprüche, **dadurch gekennzeichnet, dass** mehrere Luftaustrittsöffnungen (16) in Förderrichtung (10) hintereinander angeordnet sind.

8. Vorrichtung nach einem der vorstehenden Ansprüche, **dadurch gekennzeichnet, dass** die Luftaustrittsöffnungen (16) Schlitze sind.

9. Vorrichtung nach Anspruch 8, **dadurch gekennzeichnet, dass** die Schlitze (16) quer zur Förderrichtung (10) verlaufen.

10. Vorrichtung nach einem der vorstehenden Ansprüche, **dadurch gekennzeichnet, dass** die Weite der Luftaustrittsöffnungen (16) verstellbar ist.

11. Vorrichtung nach Anspruch 10, **dadurch gekennzeichnet, dass** die Weite der Luftaustrittsöffnungen (16) motorisch verstellbar ist.

12. Vorrichtung nach Anspruch 10 oder 11, **dadurch gekennzeichnet, dass** die Weite der Luftaustrittsöffnungen (16) mittels Blenden (18) verstellbar ist.

13. Vorrichtung nach Anspruch 12, **dadurch gekennzeichnet, dass** sich die einzelnen Blenden (18) jeweils nur über einen Teil der Breite des Förderbandes (3) erstrecken.

14. Vorrichtung nach einem der vorstehenden Ansprüche, **dadurch gekennzeichnet, dass** sich die wenigstens eine Lufteintrittsöffnung (17) über die gesamte Breite des Förderbandes (3) erstreckt oder in einen Kanal (20) mündet, welcher einen sich über die Breite des Förderbandes (3) erstreckenden Schlitz (21) hat, der dem Förderkanal (3) zugewandt ist.

15. Vorrichtung nach einem der vorstehenden Ansprüche, **dadurch gekennzeichnet, dass** die Lufteintrittsöffnungen (17) und Luftaustrittsöffnungen (16) in einer Platte ausgebildet sind, welche die obere Heißluftkammer (13) nach unten und die untere Heißluftkammer (14) nach oben begrenzt.

16. Vorrichtung nach einem der vorstehenden Ansprüche, **dadurch gekennzeichnet, dass** die Lufteintrittsöffnungen (17) in der Mitte zwischen der Eintrittsöffnung (4) und der Austrittsöffnung (5) des Förderbandes (3) angeordnet sind und dass die Luftaustrittsöffnungen (16) zu beiden Seiten der Lufteintrittsöffnung (17) vorgesehen sind.

17. Vorrichtung nach einem der vorstehenden Ansprüche, **dadurch gekennzeichnet, dass** die Leistungsfähigkeit der Gebläse (12) und der lichte Querschnitt der Luftaustrittsöffnungen (16) so aufeinander abgestimmt sind, dass die Gebläse (12) in den Heißluftkammern (13, 14) vor allen Luftaustrittsöffnungen (16) einen deutlichen Staudruck erzeugen.

18. Vorrichtung nach einem der vorstehenden Ansprüche, **dadurch gekennzeichnet, dass** in jeder Heißluftkammer (13, 14) ein oder mehrere elektrische Heizeinrichtungen (26) vorgesehen sind, die im Luftstrom eines Gebläses (12) liegen.

19. Vorrichtung nach einem der vorstehenden Ansprüche, **dadurch gekennzeichnet, dass** die Heißluftkammern (13, 14) und die sie abschließenden Luftverteiler (15) aus blankem Edelstahl bestehen.

## Claims

1. Device for heat-treating a coating of flat-bed offset printing plates by application of hot air upon the flat-bed offset printing plates, comprising
- an upper hot-air chamber (13);
- a lower hot-air chamber (14), arranged at a distance from the upper hot-air chamber (13) below the latter;
- an air-permeable endless conveyer belt (3) having a carrying run (3a), which extends between the upper and the lower hot-air chambers (13, 14);
- a first air diffuser (15) provided on the bottom of the upper hot-air chamber (13);
- a second air diffuser (15) provided on the top of the lower hot-air chamber (14);
the two air diffusers (15) being provided with air outlet openings (16) that face the conveyer belt (3) and at least one air inlet opening (17) which is connected with the intake side of one or more blowers;
and the space between the two hot-air chambers (13, 14), except for an entry opening (4) for the carrying run (3a) and an exit opening (5) for the carrying run (3a) for the conveyer belt, being closed.

2. The device as defined in Claim 1, **characterized in that** the entry opening (4) and the exit opening (5) are configured as slots.

3. The device as defined in Claim 1 or Claim 2, **characterized in that** the lower run (3b) of the conveyer belt (3) is returned below the lower hot-air chamber (14).

4. The device as defined in Claim 3, **characterized in that** the lower run (3b) of the conveyer belt (3) is returned open through ambient air.

5. The device as defined in any of the preceding claims, **characterized in that** the conveyer belt (3) consists of a wire mesh or a metal-ring mesh.

6. The device as defined in any of the preceding claims, **characterized in that** the air outlet openings (16) extend over the full width of the conveyer belt (3).

7. The device as defined in any of the preceding claims, **characterized in that** a plurality of air outlet openings (16) are arranged one behind the other in the conveying direction (10).

8. The device as defined in any of the preceding claims, **characterized in that** the air outlet openings (16) are configured as slots.

9. The device as defined in any of the preceding claims, **characterized in that** the slots extend transversely to the conveying direction (10).

10. The device as defined in any of the preceding claims, **characterized in that** the width of the air outlet openings (16) is adjustable.

11. The device as defined in Claim 10, **characterized in that** the width of the air outlet openings (16) can be adjusted by power-operated means.

12. The device as defined in Claim 10 or Claim 11, **characterized in that** the width of the air outlet openings (16) can be adjusted by means of baffles (18).

13. The device as defined in Claim 12, **characterized in that** the individual baffles extend over a part, only, of the width of the conveyer belt (3).

14. The device as defined in any of the preceding claims, **characterized in that** the at least one air inlet opening (17) extends over the full width of the conveyer belt (3) or opens into a channel (20) comprising a slot (21) which extends over the full width of the conveyer belt (3) and which faces the conveyer belt (3).

15. The device as defined in any of the preceding claims, **characterized in that** the air inlet openings (17) and the air outlet openings (16) are formed in a plate which limits the upper hot-air chamber (13) toward the bottom and the lower hot-air chamber (14) toward the top.

16. The device as defined in any of the preceding claims, **characterized in that** the air inlet openings (17) are arranged in the middle between the entry opening (4) and the exit opening (5) of the conveyer belt (3) and that the air outlet openings (16) are provided on both sides of the air inlet opening (17).

17. The device as defined in any of the preceding claims, **characterized in that** the capacity of the blowers (12) and the clear cross-section of the air outlet openings (16) are tuned one relative to the other to ensure that the blowers (12) produce a clearly notable dynamic pressure in the hot-air chambers (13, 14) in front of all air outlet openings (16).

18. The device as defined in any of the preceding claims, **characterized in that** one or more electric heating means (26) are provided in each of the hot-air chambers (13, 14) that lie in the air flow of a blower (12).

19. The device as defined in any of the preceding claims, **characterized in that** the hot-air chambers (13, 14), and the air diffusers (15) by which they are closed, are made from bright stainless steel.

## Revendications

1. Dispositif pour le traitement thermique d'un revêtement de plaques d'impression offset planographique par sollicitation des plaques d'impression offset planographique avec de l'air chaud, **caractérisé par** :
- une chambre supérieure à air chaud (13) ;
- une chambre inférieure à air chaud (14) qui est disposée en dessous de la chambre supérieure à air chaud (13), à l'écart de celle-ci ;
- une bande transporteuse sans fin (3) perméable à l'air comprenant un brin supérieur (3a) qui s'étend entre la chambre supérieure à air chaud (13) et la chambre inférieure à air chaud (14) ;
- un premier distributeur d'air (15) disposé sur le côté inférieur de la chambre supérieure à air chaud (13) ;
- un deuxième distributeur d'air (15) disposé sur le côté supérieur de la chambre inférieure à air chaud (14) ;
les deux distributeurs d'air (15) possédant des ouvertures d'évacuation d'air (16) orientées vers la bande transporteuse (3) et au moins une ouverture d'entrée d'air (17) qui est reliée au côté aspiration d'un ou de plusieurs ventilateurs (12),
l'espace ménagé entre les deux chambres à air chaud (13, 14) étant fermé à l'exception d'une ouverture d'entrée (4) pour le brin supérieur (3a) et à l'exception d'une ouverture de sortie (5) pour le brin supérieur (3a) de la bande transporteuse (3).

2. Dispositif selon la revendication 1, **caractérisé en ce que** l'ouverture d'entrée (4) et l'ouverture de sortie (5) sont réalisées en forme de fentes.

3. Dispositif selon la revendication 1 ou 2, **caractérisé en ce que** le brin inférieur (3b) de la bande transporteuse (3) est guidé en retour en dessous de la chambre inférieure à air chaud (14).

4. Dispositif selon la revendication 3, **caractérisé en ce que** le brin inférieur (3b) de la bande transporteuse (3) est guidé librement en retour à travers l'air environnant.

5. Dispositif selon l'une quelconque des revendications précédentes, **caractérisé en ce que** la bande transporteuse (3) est constituée d'un treillis de fils métalliques ou d'un treillis d'anneaux métalliques.

6. Dispositif selon l'une quelconque des revendications précédentes, **caractérisé en ce que** les ouvertures d'évacuation de l'air (16) s'étendent sur toute la largeur de la bande transporteuse (3).

7. Dispositif selon l'une quelconque des revendications précédentes, **caractérisé en ce que** plusieurs ouvertures d'évacuation de l'air (16) sont disposées les unes derrière les autres dans la direction de transports (10).

8. Dispositif selon l'une quelconque des revendications précédentes, **caractérisé en ce que** les ouvertures d'évacuation de l'air (16) sont des fentes.

9. Dispositif selon la revendication 8, **caractérisé en ce que** les fentes (16) sont disposées transversalement par rapport à la direction de transports (10).

10. Dispositif selon l'une quelconque des revendications précédentes, **caractérisé en ce que** le diamètre interne des ouvertures d'évacuation de l'air (16) est réglable.

11. Dispositif selon la revendication 10, **caractérisé en ce que** le diamètre interne des ouvertures d'évacuation de l'air (16) est réglable à l'aide d'un moteur.

12. Dispositif selon la revendication 10 ou 11, **caractérisé en ce que** le diamètre interne des ouvertures d'évacuation de l'air (16) est réglable au moyen de chicanes (18).

13. Dispositif selon la revendication 12, **caractérisé en ce que** les chicanes individuelles (18) s'étendent respectivement sur seulement une partie de la largeur de la bande transporteuse (3).

14. Dispositif selon l'une quelconque des revendications précédentes, **caractérisé en ce que** ladite au moins une ouverture d'entrée d'air (17) s'étend sur toute la largeur de la bande transporteuse (3) ou débouche dans un canal (20) qui possède une fente (21) s'étendant sur la largeur de bande transporteuse, qui est tourné vers le canal transporteur (3).

15. Dispositif selon l'une quelconque des revendications précédentes, **caractérisé en ce que** les ouvertures d'entrée d'air (17) et les ouvertures d'évacuation d'air (16) sont réalisées dans une plaque qui délimite vers le bas la chambre supérieure à air chaud (13) et qui délimite vers le haut la chambre inférieure à air chaud (14).

16. Dispositif selon l'une quelconque des revendications précédentes, **caractérisé en ce que** les ouvertures d'entrée d'air (17) sont disposées en position médiane entre l'ouverture d'entrée (4) et l'ouverture de sortie (5) de la bande transporteuse (3) et **en ce qu'**on prévoit les ouvertures d'évacuation d'air (16) des deux côtés de l'ouverture d'entrée d'air (17).

17. Dispositif selon l'une quelconque des revendications précédentes, **caractérisé en ce qu'**on fait correspondre l'une à l'autre la capacité de production des ventilateurs (12) et la section transversale interne des ouvertures d'évacuation d'air (16) de telle sorte que les ventilateurs (12), dans les chambres à air chaud (13, 14) devant toutes les ouvertures d'évacuation d'air (16), génèrent une pression dynamique nette.

18. Dispositif selon l'une quelconque des revendications précédentes, **caractérisé en ce que**, dans chaque chambre à air chaud (13, 14), on prévoit un ou plusieurs dispositifs de chauffage électrique (26) qui sont disposés dans le courant d'air d'un ventilateur (12).

19. Dispositif selon l'une quelconque des revendications précédentes, **caractérisé en ce que** les chambres à air chaud (13, 14) et les distributeurs d'air (15) qui s'y raccordent sont constitués par de l'acier spécial brillant.
